# EUROPEAN PATENT APPLICATION

(11) **EP 2 720 269 A1**
(43) Date of publication of application: **16.04.2014**
(21) Application number: 12796108.4
(22) Date of filing: 07.02.2012
(51) Int. Cl.: H01L 29/12, H01L 21/336, H01L 29/06, H01L 29/78

(54) **SEMICONDUCTOR DEVICE**

(30) Priority: 07.06.2011 JP 2011126917
(71) Applicant: Sumitomo Electric Industries, Ltd., Osaka-shi, Osaka 541-0041 (JP)
(72) Inventor: WADA, Keiji, Osaka-shi Osaka 554-0024 (JP); MASUDA, Takeyoshi, Osaka-shi Osaka 554-0024 (JP); HONAGA, Misako, Osaka-shi Osaka 554-0024 (JP); HIYOSHI, Toru, Osaka-shi Osaka 554-0024 (JP)
(74) Representative: Grünecker, Kinkeldey, Stockmair & Schwanhäusser
(86) International application number: PCT/JP2012/052709
(87) International publication number: WO 2012/169224

(57) **Abstract**

A MOSFET (1) includes a silicon carbide substrate (11), a drift layer (12) made of silicon carbide and including a main surface (12A) having an off angle of 50° or more and 65° or less with respect to a {0001} plane, and a gate oxide film (21) formed on and in contact with the main surface (12A) of the drift layer (12). The drift layer (12) includes a p type body region (14) formed to include a region (14A) in contact with the gate oxide film (21). The p type body region (14) has an impurity density of 5 × 10¹⁶ cm⁻³ or more. A plurality of p type regions (13) of p conductivity type located apart from one another in a direction perpendicular to a thickness direction of the drift layer (12) are arranged in a region in the drift layer (12) lying between the p type body region (14) and the silicon carbide substrate (11).

## Description

### TECHNICAL FIELD

The present invention relates to semiconductor devices, and more particularly to a semiconductor device capable of achieving increased flexibility in setting a threshold voltage while achieving suppressed reduction in channel mobility.

### BACKGROUND ART

In recent years, silicon carbide has been increasingly employed as a material for a semiconductor device in order to realize a higher breakdown voltage, loss reduction, use in a high-temperature environment and the like of the semiconductor device. Silicon carbide is a wide band gap semiconductor having a wider band gap than that of silicon which has been conventionally and widely used as a material for a semiconductor device. By employing silicon carbide as a material for a semiconductor device, therefore, a higher breakdown voltage, on-resistance reduction and the like of the semiconductor device can be achieved. A semiconductor device made of silicon carbide also has the advantage of exhibiting less performance degradation when used in a high-temperature environment than a semiconductor device made of silicon.

For semiconductor devices such as MOSFETs (Metal Oxide Semiconductor Field Effect Transistors) and IGBTs (Insulated Gate Bipolar Transistors) among the semiconductor devices made of silicon carbide, in which the presence or absence of formation of an inversion layer in a channel layer is controlled based on a prescribed threshold voltage to conduct or interrupt a current, various studies have been conducted on adjustment of threshold voltage and improvement in channel mobility (see Sei-Hyung Ryu et al., "Critical Issues for MOS Based Power Devices in 4H-SiC," Materials Science Forum, 2009, Vols. 615-617, pp. 743-748 (Non-Patent Literature 1), for example).

### CITATION LIST

### NON-PATENT LITERATURE

NPL 1: Sei-Hyung Ryu et al., "Critical Issues for MOS Based Power Devices in 4H-SiC," Materials Science Forum, 2009, Vols. 615-617, pp. 743-748

### SUMMARY OF INVENTION

### TECHNICAL PROBLEM

In a semiconductor device such as an N channel MOSFET or IGBT, a p type body region of p conductivity type is formed, and a channel layer is formed in the p type body region. By increasing the density (doping density) of a p type impurity (B (boron) and/or Al (aluminum), for example) in the p type body region, a threshold voltage can be shifted to a positive side, and the device can be brought closer to a normally off type or made as a normally off type. In a P channel semiconductor device, contrary to the N channel device, by increasing the density of an n type impurity in an n type body region, a threshold voltage can be shifted to a negative side, and the device can be brought closer to a normally off type or made as a normally off type.

The adjustment of threshold voltage in this manner results in significant reduction in channel mobility, however. This is because increasing the doping density causes noticeable scattering of electrons due to a dopant. For this reason, the doping density in a p type body region is set at about 1 × 10¹⁶ cm⁻³ to about 4 × 10¹⁶ cm⁻³ for example. Consequently, it has been difficult to freely set a threshold voltage while ensuring a sufficient channel mobility in a conventional semiconductor device, particularly to bring the device closer to a normally off type or make the device as a normally off type.

The present invention was made to solve such problems, and an object of the present invention is to provide a semiconductor device capable of achieving increased flexibility in setting a threshold voltage while achieving suppressed reduction in channel mobility.

### SOLUTION TO PROBLEM

A semiconductor device according to the present invention includes a substrate made of silicon carbide, a semiconductor layer made of silicon carbide of a first conductivity type, which is formed on the substrate and includes a surface having an off angle of 50° or more and 65° or less with respect to a {0001} plane, and an insulating film formed on and in contact with the surface of the semiconductor layer. The semiconductor layer includes a body region of a second conductivity type different from the first conductivity type, which is formed to include a region in contact with the insulating film. The body region has an impurity density of 5 × 10¹⁶ cm⁻³ or more. A plurality of regions of the second conductivity type located apart from one another in a direction perpendicular to a thickness direction of the semiconductor layer are arranged in a region in the semiconductor layer lying between the body region and the substrate.

The present inventors conducted a detailed study of methods for increasing flexibility in setting a threshold voltage while suppressing reduction in channel mobility, and arrived at the present invention based on the following findings.

In a conventional semiconductor device made of silicon carbide, an area in the vicinity of a surface of a semiconductor layer made of silicon carbide, the surface having an off angle of about 8° or less with respect to the {0001} plane, is utilized as a channel layer. In such semiconductor device, it is difficult to freely set a threshold voltage while ensuring a sufficient channel mobility as described above.

According to the study by the present inventors, however, it was found that opposing relation between the increase in doping density in a body region and the improvement in channel mobility was significantly relieved if a structure was employed in which a channel layer is formed in the vicinity of a surface having an off angle within a prescribed range with respect to the {0001} plane. More specifically, if a structure is employed in which a body region is formed to include a surface of a semiconductor layer made of silicon carbide, the surface having an off angle of 50° or more and 65° or less with respect to the {0001} plane, and a channel layer is formed in a region including the surface, reduction in channel mobility is significantly suppressed even if a doping density in the body region is increased.

In the semiconductor device of the present invention, an insulating film is formed on and in contact with a surface of a semiconductor layer made of silicon carbide, the surface having an off angle of 50° or more and 65° or less with respect to the {0001} plane, and a body region is formed to include a region in contact with this insulating film. That is, in the semiconductor device of the present invention, since the body region is formed to include the surface having an off angle of 50° or more and 65° or less with respect to the {0001} plane, the channel layer is formed in the region including the surface. Accordingly, even if a highly doped body region having an impurity density of 5 × 10¹⁶ cm⁻³ or more is formed and the threshold voltage is shifted to a positive side, reduction in channel mobility is suppressed. According to the present invention, therefore, a semiconductor device capable of achieving increased flexibility in setting a threshold voltage while achieving suppressed reduction in channel mobility can be provided.

It is noted that "impurity" mentioned above refers to an impurity introduced into silicon carbide to generate majority carriers.

Further, in the semiconductor device of the present invention, the plurality of regions of the second conductivity type located apart from one another in the direction perpendicular to the thickness direction of the semiconductor layer are arranged in the region in the semiconductor layer lying between the body region and the substrate. That is, the semiconductor layer in the semiconductor device of the present invention has a super junction structure. As a result, the semiconductor device of the present invention can achieve reduced on-resistance while maintaining a desired breakdown voltage.

In the semiconductor device described above, an angle formed between an off orientation of the surface of the semiconductor layer and a <01-10> direction may be 5° or less.

The <01-10> direction is a representative off orientation in a silicon carbide substrate. When manufacturing a planar MOSFET, for example, by forming a semiconductor layer by epitaxial growth on a silicon carbide substrate including a main surface having an off orientation close to the <01-10> direction, the off orientation of the surface of the semiconductor layer is close to the <01-10> direction.

In the semiconductor device described above, the surface of the semiconductor layer may have an off angle of -3° or more and 5° or less with respect to a {03-38} plane in the <01-10> direction.

As a result, the channel mobility can be further improved. The reason that the off angle with respect to the plane orientation {03-38} is set at -3° or more and +5° or less is based on examination results of relation between the channel mobility and the off angle, which showed that a particularly high channel mobility was obtained within this range.

Further, "off angle with respect to the {03-38} plane in the <01-10> direction" refers to an angle formed between an orthogonal projection of a normal of the surface of the semiconductor layer to a plane including the <01-10> direction and a <0001> direction and a normal of the {03-38} plane, and a sign thereof is positive when the orthogonal projection approaches to become parallel to the <01-10> direction, and negative when the orthogonal projection approaches to become parallel to the <0001> direction.

It is more preferable that the plane orientation of the surface of the semiconductor layer be substantially the {03-38} plane, and it is still more preferable that the plane orientation of the surface f the semiconductor layer be the {03-38} plane. That the plane orientation of the surface is substantially the {03-38} plane means that the plane orientation of the surface is within a range of off angle where the plane orientation is substantially regarded as the {03-38} plane in consideration of processing accuracy and the like, and the range of off angle in this case is a range of ±2° of off angle with respect to the {03-38} plane. As a result, the channel mobility can be further improved.

In the semiconductor device described above, an angle formed between an off orientation of the surface of the semiconductor layer and a <-2110> direction may be 5° or less.

Like the <01-10> direction, the <-2110> direction is a representative off orientation in a silicon carbide substrate. When manufacturing a planar MOSFET, for example, by forming a semiconductor layer by epitaxial growth on a silicon carbide substrate including a main surface having an off orientation close to the <-2110> direction, the off orientation of the surface of the semiconductor layer is close to the <-2110> direction.

In the semiconductor device described above, the surface of the semiconductor layer may be a surface of a carbon face side of silicon carbide.

Consequently, the channel mobility can be further improved. Here, a (0001) plane of single-crystalline silicon carbide of a hexagonal crystal is defined as a silicon face, and a (000-1) plane is defined as a carbon face. That is, if a structure is employed in which an angle formed between the off orientation of the surface of the semiconductor layer and the <01-10> direction is 5° or less, the channel mobility can be further improved by bringing the surface of the semiconductor layer closer to a (0-33-8) plane.

In the semiconductor device described above, the body region may have an impurity density of 1 × 10²⁰ cm⁻³ or less.

Even if the body region has the impurity density of 1 × 10²⁰ cm⁻³ or less, the threshold voltage can be set with sufficient flexibility. If a doping density higher than 1 × 10²⁰ cm⁻³ is employed, problems such as degradation in crystallinity may occur.

The semiconductor device described above may be of a normally off type. Even if the doping density in the body region is increased to a degree that makes the device as a normally off type in this manner, reduction in channel mobility can be sufficiently suppressed according to the semiconductor device of the present invention.

The semiconductor device described above may further include a gate electrode arranged on and in contact with the insulating film, and the gate electrode may be made of polysilicon of the second conductivity type. That is, when the second conductivity type is p type, the gate electrode may be made of p type polysilicon, and when the second conductivity type is n type, the gate electrode may be made of n type polysilicon. The p type polysilicon refers to polysilicon where the majority carriers are holes, and the n type polysilicon refers to polysilicon where the majority carriers are electrons. As a result, the threshold voltage of the semiconductor device can be controlled with a work function of the gate electrode, and the semiconductor device can be readily made as a normally off type.

The semiconductor device described above may further include a gate electrode arranged on and in contact with the insulating film, and the gate electrode may be made of n type polysilicon. As a result, the switching speed of the semiconductor device can be improved.

In the semiconductor device described above, the insulating film may have a thickness of 25 nm or more and 70 nm or less. If the thickness of the insulating film is less than 25 nm, breakdown may occur during operation. If the thickness of the insulating film is more than 70 nm, an absolute value of a gate voltage when using the insulating film as a gate insulating film needs to be increased. Thus, the above problems can be readily resolved by setting the thickness of the insulating film at 25 nm or more and 70 nm or less.

In the semiconductor device described above, the first conductivity type may be n type, and the second conductivity type may be p type. That is, the semiconductor device described above may be of N channel type. As a result, a semiconductor device where the majority carriers are electrons for which high mobility can be readily ensured can be provided.

In the semiconductor device described above, the body region may have an impurity density of 8 × 10¹⁶ cm⁻³ or more and 3 × 10¹⁸ cm⁻³ or less. Consequently, a threshold voltage of about 0 V to about 5 V can be obtained at a normal operating temperature. As a result, a semiconductor device made of silicon can be readily replaced with the semiconductor device of the present application for use, and the semiconductor device can be steadily made as a normally off type. Further, significant reduction in channel mobility resulting from increase in impurity density can be avoided.

In the semiconductor device described above, a threshold voltage at which a weak inversion layer is formed in a region in the body region which is in contact with the insulating film may be 2 V or more within a temperature range of not less than room temperature and not more than 100°C. As a result, a normally off state can be more reliably maintained at the normal operating temperature. The room temperature specifically refers to 27°C.

In the semiconductor device described above, the threshold voltage may be 3 V or more at 100°C. As a result, a normally off state can be more reliably maintained at a high operating temperature.

In the semiconductor device described above, the threshold voltage may be 1 V or more at 200°C. As a result, a normally off state can be more reliably maintained at a higher operating temperature.

In the semiconductor device described above, the threshold voltage may have a temperature dependence of -10 mV/°C or more. As a result, a normally off state can be stably maintained.

In the semiconductor device described above, the electrons may have a channel mobility of 30 cm²/Vs or more at room temperature. As a result, sufficient suppression of the on-resistance of the semiconductor device is facilitated.

In the semiconductor device described above, the electrons may have a channel mobility of 50 cm²/Vs or more at 100°C. As a result, the on-resistance of the semiconductor device can be sufficiently suppressed at a high operating temperature.

In the semiconductor device described above, the electrons may have a channel mobility of 40 cm²/Vs or more at 150°C. As a result, the on-resistance of the semiconductor device can be sufficiently suppressed at a higher operating temperature.

In the semiconductor device described above, the channel mobility of electrons may have a temperature dependence of -0.3 cm²/Vs °C or more. As a result, the on-resistance of the semiconductor device can be stably suppressed.

In the semiconductor device described above, a barrier height at an interface between the semiconductor layer and the insulating film may be 2.2 eV or more and 2.6 eV or less.

By increasing the barrier height, a leak current (tunnel current) flowing through the insulating film serving as a gate insulating film can be suppressed. When the epitaxial growth layer is made of silicon carbide, however, if a crystal face simply having a large barrier height with an insulating film is employed as a surface in contact with the insulating film, the channel mobility is reduced. To address this problem, a crystal face having a barrier height of 2.2 eV or more and 2.6 eV or less is employed as a surface in contact with the insulating film, thereby ensuring a high channel mobility while suppressing the leak current. Such barrier height can be readily achieved by employing a semiconductor layer including a surface having an off angle of 50° or more and 65° or less with respect to the {0001} plane. It is noted that the barrier height refers to the size of a band gap between a conduction band of the semiconductor layer and a conduction band of the insulating film.

In the semiconductor device described above, in an on state, channel resistance which is a resistance value in a channel layer formed in the body region may be smaller than drift resistance which is a resistance value in the semiconductor layer other than the channel layer. As a result, the on-resistance of the semiconductor device can be reduced. Such relation between the channel resistance and the drift resistance can be readily achieved by employing a semiconductor layer including a surface having an off angle of 50° or more and 65° or less with respect to the {0001} plane.

The semiconductor device described above may be a DiMOSFET (Double Implanted MOSFET), or a trench MOSFET. The semiconductor device of the present invention is applicable to semiconductor devices having various structures.

### ADVANTAGEOUS EFFECTS OF INVENTION

As is clear from the description above, according to the present invention, a semiconductor device capable of achieving increased flexibility in setting a threshold voltage while achieving suppressed reduction in channel mobility can be provided.

### BRIEF DESCRIPTION OF DRAWINGS

Fig. 1 is a schematic cross-sectional view showing a structure of a MOSFET in a first embodiment.
Fig. 2 is a flowchart schematically illustrating a method of manufacturing the MOSFET in the first embodiment.
Fig. 3 is a schematic cross-sectional view for explaining the method of manufacturing the MOSFET in the first embodiment.
Fig. 4 is a schematic cross-sectional view for explaining the method of manufacturing the MOSFET in the first embodiment.
Fig. 5 is a schematic cross-sectional view for explaining the method of manufacturing the MOSFET in the first embodiment.
Fig.6 is a schematic cross-sectional view for explaining the method of manufacturing the MOSFET in the first embodiment.
Fig. 7 is a schematic cross-sectional view for explaining the method of manufacturing the MOSFET in the first embodiment.
Fig. 8 is a schematic cross-sectional view for explaining the method of manufacturing the MOSFET in the first embodiment.
Fig.9 is a schematic cross-sectional view for explaining the method of manufacturing the MOSFET in the first embodiment.
Fig. 10 is a schematic cross-sectional view for explaining the method of manufacturing the MOSFET in the first embodiment.
Fig. 11 is a schematic cross-sectional view for explaining the method of manufacturing the MOSFET in the first embodiment.
Fig. 12 is a schematic perspective view showing a structure of a MOSFET in a second embodiment.
Fig. 13 is a flowchart schematically illustrating a method of manufacturing the MOSFET in the second embodiment.
Fig. 14 is a schematic cross-sectional view for explaining the method of manufacturing the MOSFET in the second embodiment.
Fig. 15 is a schematic cross-sectional view for explaining the method of manufacturing the MOSFET in the second embodiment.
Fig. 16 is a schematic cross-sectional view for explaining the method of manufacturing the MOSFET in the second embodiment.
Fig. 17 is a schematic cross-sectional view for explaining the method of manufacturing the MOSFET in the second embodiment.
Fig. 18 is a schematic cross-sectional view for explaining the method of manufacturing the MOSFET in the second embodiment.
Fig. 19 is a schematic cross-sectional view for explaining the method of manufacturing the MOSFET in the second embodiment.
Fig. 20 is a schematic cross-sectional view for explaining the method of manufacturing the MOSFET in the second embodiment.
Fig. 21 is a schematic cross-sectional view for explaining the method of manufacturing the MOSFET in the second embodiment.
Fig. 22 is a schematic cross-sectional view for explaining the method of manufacturing the MOSFET in the second embodiment.

### DESCRIPTION OF EMBODIMENTS

Embodiments of the present invention will be described hereinafter with reference to the drawings. It is noted that the same or corresponding parts are designated by the same reference numerals in the following drawings, and description thereof will not be repeated. In the present specification, an individual orientation is indicated with [], a group orientation is indicated with <>, an individual plane is indicated with (), and a group plane is indicated with { }. Although "-" (bar) is supposed to be attached atop a numeral of an negative index in terms of crystallography, a negative sign is attached before a numeral in the present specification.

### (First Embodiment)

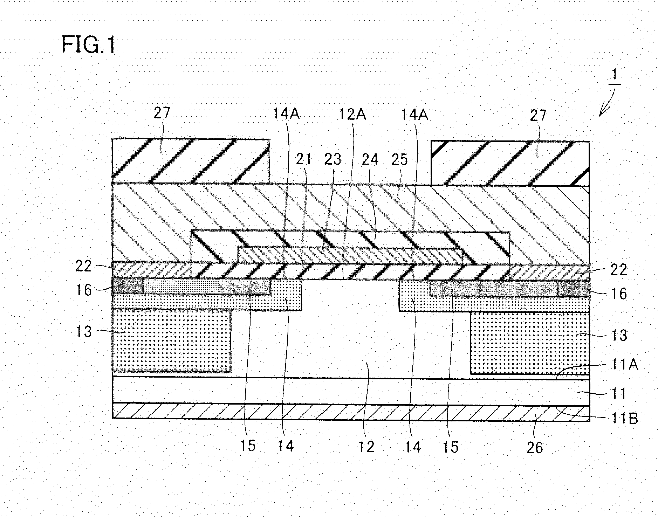

A first embodiment which is one embodiment of the present invention will be described first. Referring to Fig. 1, a MOSFET 1 which is a semiconductor device (DiMOSFET) in this embodiment includes a silicon carbide substrate 11 of n conductivity type (first conductivity type), a drift layer 12 which is a semiconductor layer of n conductivity type made of silicon carbide, p type regions 13 of p conductivity type (second conductivity type), a pair of p type body regions 14 of p conductivity type, n⁺ regions 15 of n conductivity type, and p⁺ regions 16 of p conductivity type.

Drift layer 12 is formed on one main surface 11A of silicon carbide substrate 11, and is of n conductivity type by containing an n type impurity. The n type impurity contained in drift layer 12 is N (nitrogen), for example, and is contained in a concentration (density) lower than that of an n type impurity contained in silicon carbide substrate 11. Drift layer 12 is an epitaxial growth layer formed on one main surface 11A of silicon carbide substrate 11.

The pair of p type body regions 14 is formed apart from each other in drift layer 12 to include a main surface 12A opposite to a main surface on which silicon carbide substrate 11 is formed, and is of p conductivity type by containing a p type impurity (impurity of p conductivity type). The p type impurity contained in p type body regions 14 is aluminum (Al) and/or boron (B), for example. Main surface 12A has an off angle of 50° or more and 65° or less with respect to the {0001} plane. P type body regions 14 have an impurity density of 5 × 10¹⁶ cm⁻³ or more.

Each of n⁺ regions 15 is formed in each of the pair of p type body regions 14 to include main surface 12A and to be surrounded by each of p type body regions 14. N⁺ regions 15 contain an n type impurity such as P in a concentration (density) higher than that of the n type impurity contained in drift layer 12. Each of p⁺ regions 16 is formed in each of the pair of p type body regions 14 to include main surface 12A, to be surrounded by each of p type body regions 14, and to be adjacent to each of n⁺ regions 15. P⁺ regions 16 contain a p type impurity such as Al in a concentration (density) higher than that of the p type impurity contained in p type body regions 14.

The plurality of p type regions 13 are arranged apart from one another in a direction perpendicular to a thickness direction of drift layer 12 (direction along main surface 11A of silicon carbide substrate 11), in a region in drift layer 12 lying between p type body regions 14 and silicon carbide substrate 11.

More specifically, p type regions 13 in MOSFET 1 in this embodiment have the following features. It is noted that the structure of the semiconductor device in the present invention is not limited to the following manner. P type regions 13 are formed such that one p type region 13 corresponds to one p type body region 14. In addition, a distance between adjacent p type body regions 14 is smaller than a distance between p type regions 13 arranged correspondingly to those p type body regions 14. Further, p type regions 13 are formed in contact with p type body regions 14. There is a gap between p type regions 13 and silicon carbide substrate 11. Each of p type regions 13 has a columnar shape, more specifically a rectangular parallelepiped shape.

Referring to Fig. 1, MOSFET 1 further includes a gate oxide film 21 as a gate insulating film, a gate electrode 23, a pair of source contact electrodes 22, an interlayer insulating film 24, a source line 25, a drain electrode 26, and a passivation protection film 27.

Gate oxide film 21 is formed on and in contact with main surface 12A of drift layer 12 as a semiconductor layer to extend from an upper surface of one of n⁺ regions 15 to an upper surface of the other n⁺ region 15, and is made of a dielectric such as silicon dioxide (SiO₂ and/or Al₂O₃.

Gate electrode 23 is arranged in contact with gate oxide film 21 to extend from a portion above one of n⁺ regions 15 to a portion above the other n⁺ region 15. Gate electrode 23 is made of a conductor such as polysilicon including an impurity, Al, W, and/or Mo.

Each of source contact electrodes 22 is arranged in contact with main surface 12A to extend from a portion above each of the pair of n⁺ regions 15 in a direction away from gate oxide film 21 to reach a portion above each of p⁺ regions 16. Source contact electrodes 22 are made of a material capable of making ohmic contact with n⁺ regions 15 and p⁺ regions 16, such as Niₓsi_{y} (nickel silicide), TiₓSi_{y} (titanium silicide), AlₓSi_{y} (aluminum silicide), and/or TiₓAl_{y}Si_{z} (titanium aluminum silicide).

Interlayer insulating film 24 is formed to surround gate electrode 23 and to extend from a portion above one of p type body regions 14 to a portion above the other p type body region 14 above main surface 12A of drift layer 12, and is made of an insulator such as silicon dioxide (SiO₂ and/or silicon nitride (SiN).

Source line 25 surrounds interlayer insulating film 24, and extends to upper surfaces of source contact electrodes 22, above main surface 12A of drift layer 12. Source line 25 is made of a conductor such as Al, and is electrically connected to n⁺ regions 15 via source contact electrodes 22.

Drain electrode 26 is formed in contact with a main surface 11B of silicon carbide substrate 11 opposite to the surface on which drift layer 12 is formed. Drain electrode 26 is made of a material capable of making ohmic contact with silicon carbide substrate 11, such as NiₓSi_{y}, and is electrically connected to silicon carbide substrate 11.

Passivation protection film 27 is formed on source line 25 to cover source line 25. Passivation protection film 27 is made of an insulator such as silicon dioxide and/or silicon nitride (SiN).

That is, MOSFET 1 which is a DiMOSFET in this embodiment includes silicon carbide substrate 11, drift layer 12 as a semiconductor layer made of silicon carbide of the first conductivity type (n type), which is formed on silicon carbide substrate 11 and includes the surface (main surface 12A) having an off angle of 50° or more and 65° or less with respect to the {0001} plane, and gate oxide film 21 as an insulating film formed on and in contact with main surface 12A of drift layer 12. Drift layer 12 includes p type body regions 14 of the second conductivity type (p type) formed to include regions 14A in contact with gate oxide film 21. P type body regions 14 have an impurity density of 5 × 10¹⁶ cm⁻³ or more. The plurality of p type regions 13 of the second conductivity type (p type) located apart from one another in the direction perpendicular to the thickness direction of drift layer 12 are arranged in the region in drift layer 12 lying between p type body regions 14 and silicon carbide substrate 11.

Next, the operation of MOSFET 1 will be described. Referring to Fig. 1, when gate electrode 23 has a voltage lower than a threshold voltage, i.e., in an off state, a pn junction between each of p type body regions 14 and drift layer 12 positioned immediately below gate oxide film 21 is reverse biased and non-conducting even if a voltage is applied to drain electrode 26. On the other hand, when a voltage equal to or higher than the threshold voltage is applied to gate electrode 23, an inversion layer is formed in a channel region in each of p type body regions 14 in contact with gate oxide film 21. As a result, n⁺ regions 15 and drift layer 12 are electrically connected to each other, causing a current to flow between source line 25 and drain electrode 26.

In MOSFET 1, main surface 12A of drift layer 12 opposite to the surface on which silicon carbide substrate 11 is formed has an off angle of 50° or more and 65° or less with respect to the {0001} plane. Thus, region 14A in each of p type body regions 14 which is in contact with gate oxide film 21 has an off angle of 50° or more and 65° or less with respect to the {0001} plane, and a channel layer is formed in the vicinity of region 14A. Accordingly, even if highly doped p type body regions 14 having a p type impurity density of 5 × 10¹⁶ cm⁻³ or more are formed and the threshold voltage is shifted to a positive side, reduction in mobility of carriers (electrons) (channel mobility) in the channel layer is suppressed. Therefore, MOSFET 1 can be brought closer to a normally off type or made as a normally off type by the shift of the threshold voltage to a positive side while reduction in channel mobility is suppressed. To further shift the threshold voltage to a positive side, the p type impurity density in p type body regions 14 may be set at 1 × 10¹⁷ cm⁻³ or more, or further at 5 × 10¹⁷ cm⁻³ or more.

Further, in MOSFET 1, p type regions 13 are arranged apart from one another in the direction perpendicular to the thickness direction of drift layer 12, in the region in drift layer 12 lying between p type body regions 14 and silicon carbide substrate 11. That is, drift layer 12 of MOSFET 1 has a super junction structure in which pn junctions are repeatedly arranged in the direction along main surface 11A of silicon carbide substrate 11. MOSFET 1 has a high breakdown voltage due to the action of a depletion layer formed by the pn junction. The on-resistance is reduced since a region in drift layer 12 where p-type regions 13 are not formed serves as a current path. As a result, MOFET 1 is a semiconductor device capable of achieving reduced loss while ensuring a high breakdown voltage.

It is preferable that an angle formed between an off orientation of main surface 12A of drift layer 12 and the <01-10> direction be 5° or less. As a result, the manufacture of MOSFET 1 by using silicon carbide substrate 11 having the representative off orientation in the <01-10> direction is facilitated.

It is preferable that main surface 12A have an off angle of -3° or more and 5° or less with respect to the {03-38} plane in the <01-10> direction, and it is more preferable that main surface 12A be substantially the {03-38} plane. As a result, the channel mobility can be further improved.

In MOSFET 1, an angle formed between the off orientation of main surface 12A and the <-2110> direction may be 5° or less. As a result, the manufacture of MOSFET 1 by using silicon carbide substrate 11 having the representative off orientation in the <-2110> direction is facilitated.

It is preferable that main surface 12A be a surface of a carbon face side of silicon carbide. As a result, the channel mobility can be further improved.

It is preferable that p type body regions 14 have a p type impurity density of 1 × 10²⁰ cm⁻³ or less. As a result, degradation in crystallinity and the like can be suppressed.

MOSFET 1 may be of a normally off type. Even if the doping density in p type body regions 14 is increased to a degree that makes MOSFET 1 as a normally off type in this manner, reduction in channel mobility can be sufficiently suppressed according to MOSFET 1.

In MOSFET 1, gate electrode 23 may be made of p type polysilicon. As a result, the threshold voltage can be readily shifted to a positive side, and MOSFET 1 can be readily made as a normally off type.

In MOSFET 1, gate electrode 23 may be made of n type polysilicon. As a result, the switching speed of MOSFET 1 can be improved.

In MOSFET 1, p type body regions 14 may have a p type impurity density of 8 × 10¹⁶ cm⁻³ or more and 3×10¹⁸ cm⁻³ or less. Consequently, a threshold voltage of about 0 V to about 5 V can be obtained at a normal operating temperature. As a result, a MOSFET made of silicon can be readily replaced with MOSFET 1 for use, and MOSFET 1 can be stably made as a normally off type. Further, significant reduction in channel mobility resulting from increase in impurity density can be avoided.

In MOSFET 1, gate oxide film 21 may have a thickness of 25 nm or more and 70 nm or less. If the thickness of gate oxide film 21 is less than 25 nm, breakdown may occur during operation, while if the thickness is more than 70 nm, a gate voltage needs to be increased. It is thus preferable that gate oxide film 21 have a thickness of 25 nm or more and 70 nm or less.

In MOSFET 1, the threshold voltage may be 2 V or more within a temperature range of not less than room temperature and not more than 100°C. As a result, a normally off state can be more reliably maintained at the normal operating temperature.

In MOSFET 1, the threshold voltage may be 3 V or more at 100°C. As a result, a normally off state can be more reliably maintained at a high operating temperature.

In MOSFET 1, the threshold voltage may be 1 V or more at 200°C. As a result, a normally off state can be more reliably maintained at a higher operating temperature.

In MOSFET 1, the threshold voltage may have a temperature dependence of -10 mV/°C or more. As a result, a normally off state can be stably maintained.

In MOSFET 1, it is preferable that the electrons have a channel mobility of 30 cm²/Vs or more at room temperature. As a result, sufficient suppression of the on-resistance of MOSFET 1 is facilitated.

In MOSFET 1, the electrons may have a channel mobility of 50 cm²/Vs or more at 100°C. As a result, the on-resistance of MOSFET 1 can be sufficiently suppressed at a high operating temperature.

In MOSFET 1, the electrons may have a channel mobility of 40 cm²/Vs or more at 150°C. As a result, the on-resistance of MOSFET 1 can be sufficiently suppressed at a higher operating temperature.

In MOSFET 1, the channel mobility of electrons may have a temperature dependence of -0.3 cm²/Vs °C or more. As a result, the on-resistance of MOSFET 1 can be stably suppressed.

In MOSFET 1, a barrier height at an interface between drift layer 12 and gate oxide film 21 may be 2.2 eV or more and 2.6 eV or less. As a result, a high channel mobility can be ensured while a leak current is suppressed.

In MOSFET 1, in an on state, channel resistance which is a resistance value in the channel layer formed in each of p type body regions 14 may be smaller than drift resistance which is a resistance value in drift layer 12 other than p type body regions 14. As a result, the on-resistance of MOSFET 1 can be reduced.

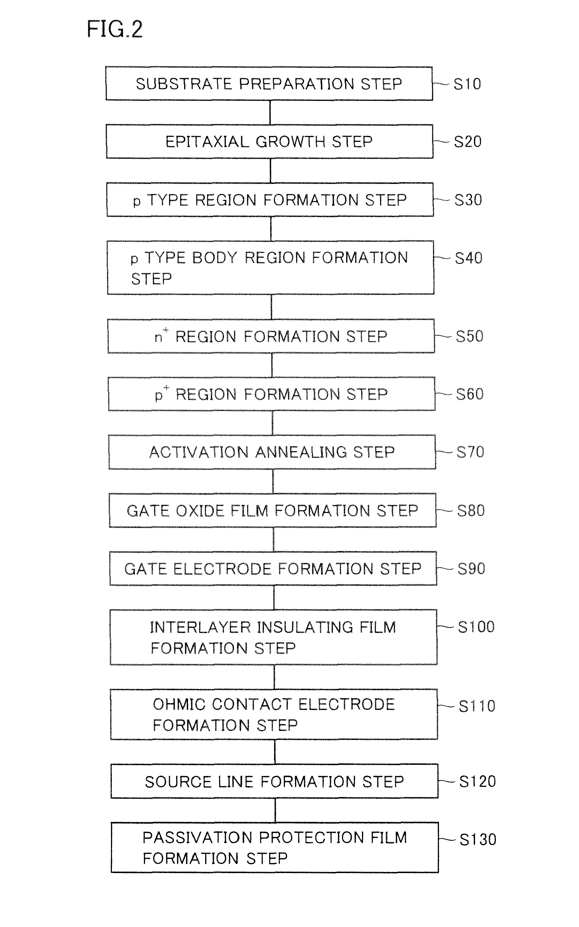

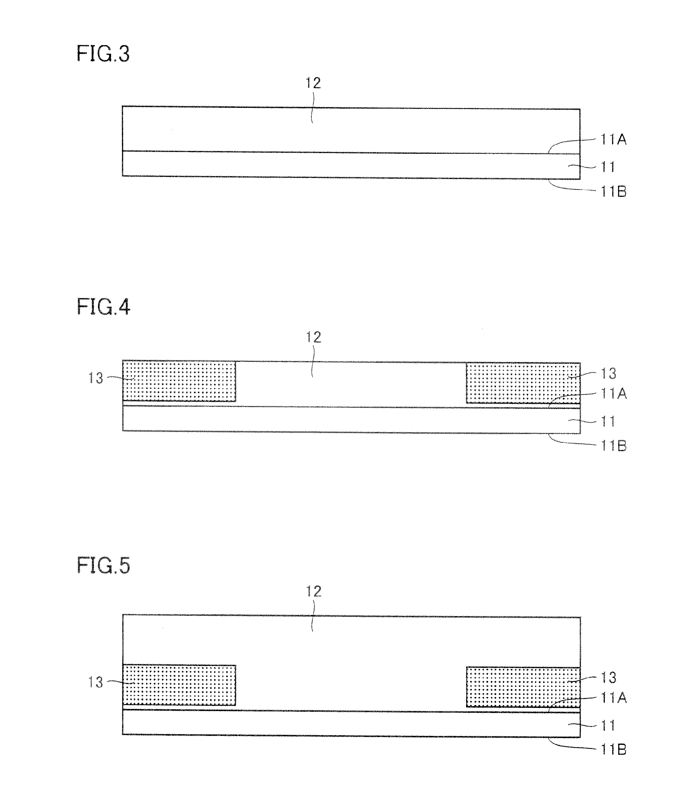

Next, an exemplary method of manufacturing MOSFET 1 in the first embodiment will be described with reference to Figs. 2 to 11. Referring to Fig. 2, in the method of manufacturing MOSFET 1 in this embodiment, a substrate preparation step is first performed as a step (S10). In this step (S 10), referring to Fig. 3, silicon carbide substrate 11 including main surface 1 1 A having an off angle of 50° or more and 65° or less with respect to the {0001} plane is prepared.

Next, an epitaxial growth step is performed as a step (S20). In this step (S20), referring to Fig. 3, drift layer 12 made of silicon carbide is formed by epitaxial growth on one main surface 11 A of silicon carbide substrate 11.

Next, a p type region formation step is performed as a step (S30). In this step (S30), referring to Figs. 3 and 4, ion implantation for forming p type regions 13 is performed. Specifically, Al (aluminum) ions are implanted into drift layer 12, for example, to form p type regions 13. The Al ions are implanted to a concentration (density) of about 1 × 10¹⁶ cm⁻³, for example.

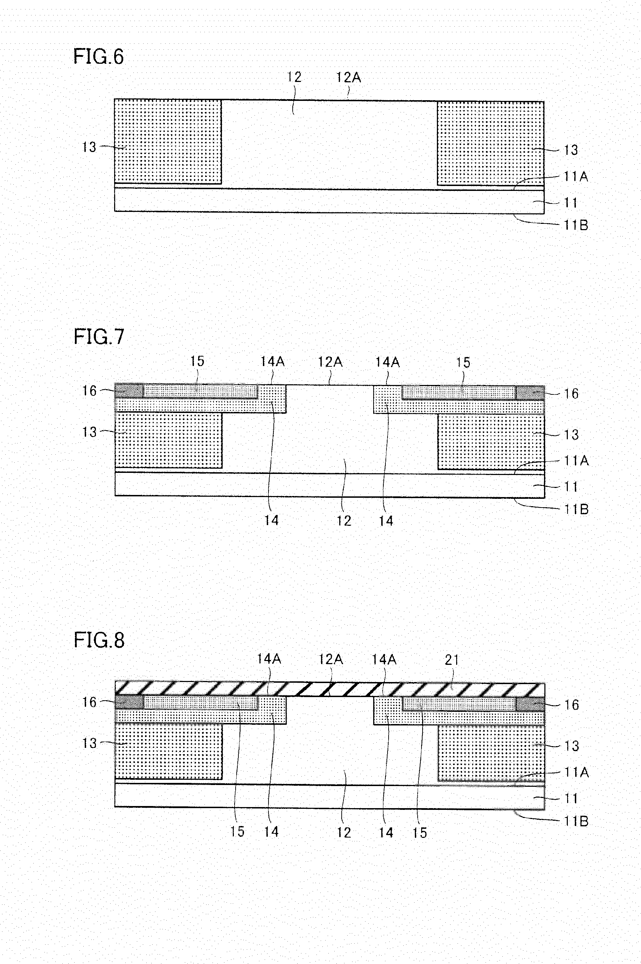

Here, the thickness of drift layer 12 needs to be determined depending on a required breakdown voltage. Thus, the above steps (S20) and (S30) may be repeated in order to increase the thickness of drift layer 12. That is, referring to Figs. 5 and 6, drift layer 12 can be further formed by epitaxial growth on drift layer 12 in which p type regions 13 have been formed, and then p type regions 13 can be formed by ion implantation, to increase the thicknesses of drift layer 12 and p type regions 13.

Next, a p type body region formation step is performed as a step (S40). In this step (S40), referring to Fig. 7, Al ions are implanted into drift layer 12, for example, to form p type body regions 14. Next, an n⁺ region formation step is performed as a step (S50). In this step (S50), referring to Fig. 7, P (phosphorus) ions are implanted into p type body regions 14, for example, to form n⁺ regions 15 in p type body regions 14. Furthermore, a p⁺ region formation step is performed as a step (S60). In this step (S60), referring to Fig. 7, Al ions are implanted into p type body regions 14, for example, to form p⁺ regions 16 in p type body regions 14. Each of the ion implantations for forming p type regions 13, p type body regions 14, n⁺ regions 15 and p⁺ regions 16 can be performed by forming a mask layer, which is made of silicon dioxide (SiO₂ and has an opening in a desired region where the ion implantations should be performed, on the main surface of drift layer 12.

Next, an activation annealing step is performed as a step (S70). In this step (S70), heat treatment is conducted by heating to between about 1700°C and about 1800°C in an atmosphere of inert gas such as argon and maintaining it for 5 to 30 minutes, for example. As a result, the impurities (ions) implanted in the above steps (S30) to (S60) are activated.

Next, a gate oxide film formation step is performed as a step (S80). In this step (S80), referring to Figs. 7 and 8, heat treatment is conducted by heating to between 1100°C and 1300°C in an oxygen atmosphere and maintaining it for about 60 minutes, for example, to form oxide film (gate oxide film) 21.

After this step (S80), a NO annealing step may be performed. In this step, heat treatment is conducted by heating in a nitrogen monoxide (NO) gas as an atmosphere gas. The condition for this heat treatment may be such that a temperature of 1100°C or more and 1300°C or less is maintained for about 60 minutes. Such heat treatment introduces nitrogen atoms into an interface region between oxide film 21 and drift layer 12. As a result, the formation of an interface state in the interface region between oxide film 21 and drift layer 12 is suppressed, thereby improving the channel mobility in finally obtained MOSFET 1. While a process using the NO gas as an atmosphere gas is employed in this embodiment, a process using another gas capable of introducing nitrogen atoms into the interface region between oxide film 21 and drift layer 12 may be employed.

Next, an Ar annealing step may be performed. In this step, heat treatment is conducted by heating in an argon (Ar) gas as an atmosphere gas. The condition for this heat treatment may be such that a temperature equal to or higher than the heating temperature in the above NO annealing step and lower than a melting point of oxide film 21 (specifically a temperature of about 1100°C to about 1300°C) is maintained for about 60 minutes, for example. As a result of this heat treatment, the formation of the interface state in the interface region between oxide film 21 and drift layer 12 is further suppressed, thereby improving the channel mobility in finally obtained MOSFET 1. While a process using the Ar gas as an atmosphere gas is employed in this embodiment, a process using another inert gas such as a nitrogen gas instead of the Ar gas may be employed.

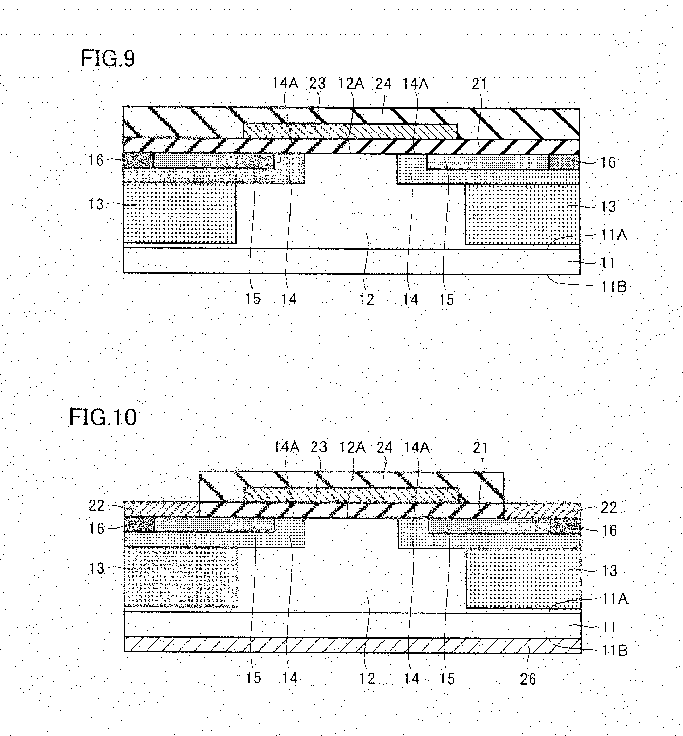

Next, a gate electrode formation step is performed as a step (S90). Referring to Figs. 8 and 9, in this step (S90), after a polysilicon film (conductor film) is formed with LPCVD (Low Pressure Chemical Vapor Deposition), for example, a mask is formed with photolithography, and the polysilicon film is processed with etching such as RIE (Reactive Ion Etching), to form gate electrode 23 made of polysilicon which is a conductor including a highly concentrated impurity.

Next, an interlayer insulating film formation step is performed as a step (S100). In this step (S100), referring to Fig. 9, interlayer insulating film 24 made of SiO₂ which is an insulator is formed with P(Plasma)-CVD, for example, to surround gate electrode 23 above main surface 12A. The thickness of interlayer insulating film 24 may be set at about 1 µm, for example. Next, referring to Fig. 10, portions of interlayer insulating film 24 and oxide film 21 in a region where source contact electrode 22 is to be formed in a step (S110) to be described later are removed with photolithography and etching. Interlayer insulating film 24 is thus formed into a desired shape.

Next, an ohmic contact electrode formation step is performed as a step (S 110). In this step (S110), referring to Fig. 10, a nickel (Ni) film formed with evaporation, for example, is heated and silicidized, to form source contact electrodes 22 and drain electrode 26.

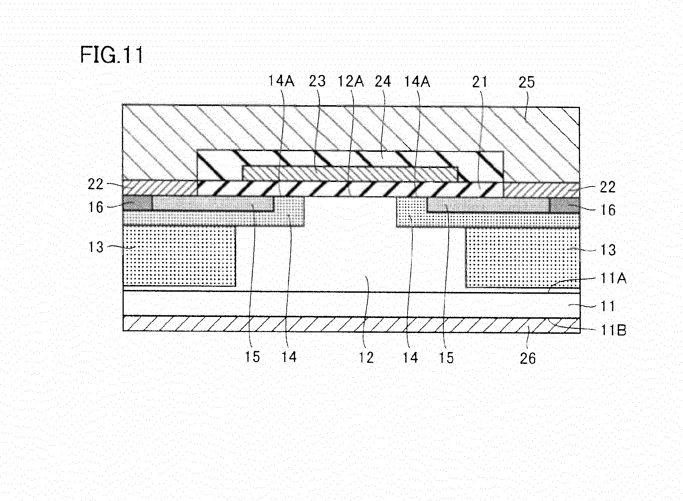

Next, a source line formation step is performed as a step (S 120). In this step (S120), referring to Figs. 10 and 11, source line 25 which is a conductor is formed with evaporation, for example, to surround interlayer insulating film 24 and to extend to the upper surfaces of n⁺ regions 15 and source contact electrodes 22 above main surface 12A. Source line 25 can be formed by successively evaporating Ti (titanium) having a thickness of 50 to 200 nm, Al having a thickness of 2 to 8 µm, and AlSi.

Next, a passivation protection film formation step is performed as a step (S130). In this step (S130), referring to Figs. 11 and 1, passivation protection film 27 is formed to cover source line 25. Passivation protection film 27 can be formed by forming a film made of an insulator such as SiO₂, SiN, and/or polyimide and having a thickness of about 0.5 µm to about 3 µm, for example. Following the above procedure, MOSFET 1 in this embodiment is completed. (Second Embodiment)

A second embodiment which is another embodiment of the present invention will now be described. A MOSFET 3 which is a semiconductor device in the second embodiment basically has a similar structure to that of MOSFET 1 in the first embodiment including the plane orientation of the surface of the semiconductor layer in contact with the insulating film (gate oxide film), the p type impurity density in the p type body regions, and the super junction structure formed in the drift layer, and thus operates in a similar manner and has similar effects.

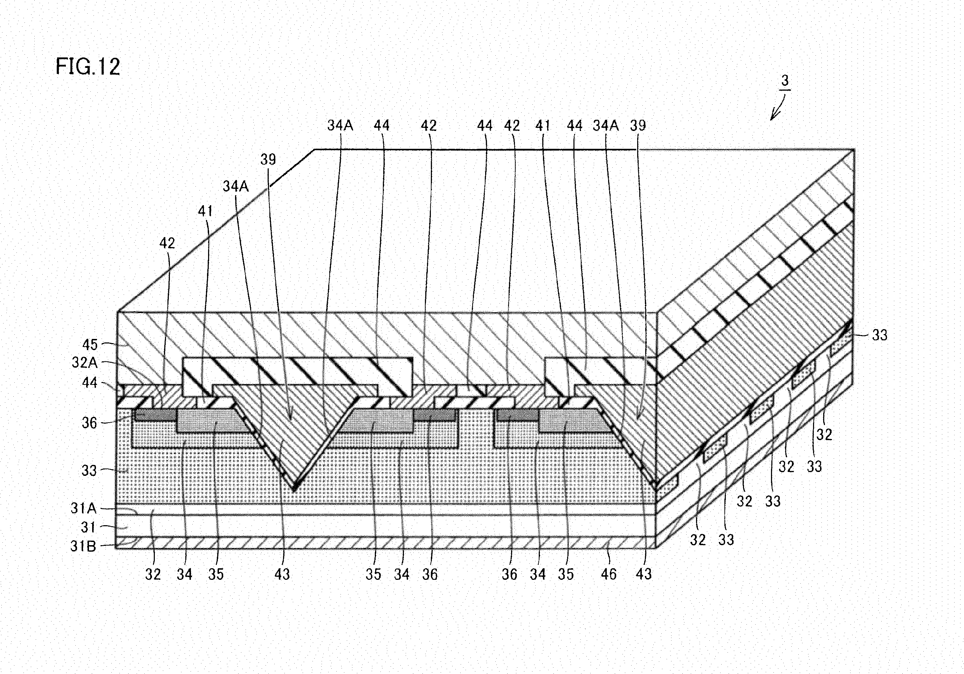

Namely, referring to Fig. 12, MOSFET 3 in the second embodiment is a trench MOSFET in which a channel layer is formed along a trench formed in a semiconductor layer, and includes a silicon carbide substrate 31 of n conductivity type, a drift layer 32 which is a semiconductor layer of n conductivity type made of silicon carbide, p type regions 33 of p conductivity type, p type body regions 34 of p conductivity type, n⁺ regions 35 of n conductivity type, and p⁺ regions 36 of p conductivity type.

Drift layer 32 is formed on one main surface 31A of silicon carbide substrate 31, and is of n conductivity type by containing an n type impurity. The n type impurity contained in drift layer 32 is nitrogen, for example, and is contained in a concentration (density) lower than that of the n type impurity contained in silicon carbide substrate 31. Drift layer 32 is an epitaxial growth layer formed on one main surface 31 A of silicon carbide substrate 31.

Drift layer 32 includes a trench 39 tapered such that its width gradually narrows toward silicon carbide substrate 31 from the side opposite to silicon carbide substrate 31.

Each of p type body regions 34 is formed in drift layer 32 to include a main surface 32A opposite to a main surface on which silicon carbide substrate 31 is formed, and also to include a surface 34A exposed at a surface of trench 39, and is of p conductivity type by containing a p type impurity. The p type impurity contained in p type body regions 34 is aluminum and/or boron, for example. Surface 34A has an off angle of 50° or more and 65° or less with respect to the {0001} plane. P type body regions 34 have an impurity density of 5 × 10¹⁶ cm⁻³ or more.

Each of n⁺ regions 35 is formed in each of p type body regions 34 to include main surface 32A. N⁺ regions 35 contain an n type impurity such as P in a concentration (density) higher than that of the n type impurity contained in drift layer 32. Each of p⁺ regions 36 is formed in each of p type body regions 34 to include main surface 32A, and to be adjacent to each of n⁺ regions 35. P⁺ regions 36 contain a p type impurity such as Al in a concentration (density) higher than that of the p type impurity contained in p type body regions 34. Trench 39 is formed through n⁺ regions 35 and p type body regions 34 to reach drift layer 32.

P type regions 33 are arranged apart from one another in a direction perpendicular to a thickness direction of drift layer 32 (direction along main surface 31 A of silicon carbide substrate 31), in a region in drift layer 32 lying between p type body regions 34 and silicon carbide substrate 31.

More specifically, p type regions 33 in MOSFET 3 in this embodiment have the following features. It is noted that the structure of the semiconductor device in the present invention is not limited to the following manner. The plurality of p type regions 33 are arranged apart from one another along a direction in which trench 39 extends. Further, p type regions 33 are formed in contact with p type body regions 34. There is a gap between p type regions 33 and silicon carbide substrate 31.

Referring to Fig. 12, MOSFET 3 further includes a gate oxide film 41 as a gate insulating film, a gate electrode 43, source contact electrodes 42, an interlayer insulating film 44, a source line 45, a drain electrode 46, and a passivation protection film (not shown).

Gate oxide film 41 is formed to cover the surface of trench 39 and to extend to main surface 32A, and is made of silicon dioxide (SiO₂), for example.

Gate electrode 43 is arranged in contact with gate oxide film 41 to fill trench 39 and to extend to main surface 32A. Gate electrode 43 is made of a conductor such as polysilicon including an impurity, or Al.

Each of source contact electrodes 42 is arranged in contact with each of n⁺ regions 35 and each of p⁺ regions 36 by extending from a portion above each of n⁺ regions 35 to a portion above each of p⁺ regions 36. Source contact electrodes 42 are made of a material capable of making ohmic contact with n⁺ regions 35 and p⁺ regions 36, such as NiₓSi_{y} (nickel silicide), TiₓSi_{y} (titanium silicide), AlₓSi_{y} (aluminum silicide), and/or TiₓAl_{y}Si_{z} (titanium aluminum silicide).

Interlayer insulating film 44 is formed to surround gate electrode 43 and to separate gate electrode 43 from source contact electrode 42 above main surface 32A of drift layer 32, and is made of silicon dioxide (SiO₂ which is an insulator, for example.

Source line 45 surrounds interlayer insulating film 44, and extends to upper surfaces of source contact electrodes 42, above main surface 32A of drift layer 32. Source line 45 is made of a conductor such as Al, and is electrically connected to n⁺ regions 35 via source contact electrodes 42.

Drain electrode 46 is formed in contact with a main surface 31B of silicon carbide substrate 31 opposite to the surface on which drift layer 32 is formed. Drain electrode 46 is made of a material capable of making ohmic contact with silicon carbide substrate 31, such as NiₓSi_{y}, and is electrically connected to silicon carbide substrate 31.

The passivation protection film (not shown) is formed on source line 45 to cover source line 45. The passivation protection film is made of an insulator such as silicon dioxide.

That is, MOSFET 3 which is a trench MOSFET in this embodiment includes silicon carbide substrate 31, drift layer 32 as a semiconductor layer made of silicon carbide of the first conductivity type (n type), which is formed on silicon carbide substrate 31 and includes the surface (surface 34A) having an off angle of 50° or more and 65° or less with respect to the {0001} plane, and gate oxide film 41 as an insulating film formed on and in contact with surface 34A of drift layer 32. Drift layer 32 includes p type body regions 34 of the second conductivity type (p type) formed to include surfaces 34A in contact with gate oxide film 41. P type body regions 34 have an impurity density of 5 × 10¹⁶ cm⁻³ or more. The plurality of p type regions 33 of the second conductivity type (p type) located apart from one another in the direction perpendicular to the thickness direction of drift layer 32 are arranged in the region in drift layer 32 lying between p type body regions 34 and silicon carbide substrate 31.

In MOSFET 3, surface 34A of each of p type body regions 34 which is in contact with gate oxide film 41 has an off angle of 50° or more and 65° or less with respect to the {0001} plane, and a channel layer is formed in the vicinity of surface 34A. Accordingly, even if highly doped p type body regions 34 having a p type impurity density of 5 × 10¹⁶ cm⁻³ or more are formed and the threshold voltage is shifted to a positive side, reduction in mobility of carriers (electrons) (channel mobility) in the channel layer is suppressed. Therefore, MOSFET 3 can be brought closer to a normally off type or made as a normally off type by the shift of the threshold voltage to a positive side while reduction in channel mobility is suppressed.

Further, in MOSFET 3, p type regions 33 are arranged apart from one another in the direction perpendicular to the thickness direction of drift layer 32, in the region in drift layer 32 lying between p type body regions 34 and silicon carbide substrate 31. That is, drift layer 32 of MOSFET 3 has a super junction structure in which pn junctions are repeatedly arranged in the direction along the direction in which trench 39 extends. MOSFET 3 has a high breakdown voltage due to the action of a depletion layer formed by the pn junction. The on-resistance is reduced since a region in drift layer 32 where p-type regions 33 are not formed serves as a current path. As a result, MOSFET 3 is a semiconductor device capable of achieving reduced loss while ensuring a high breakdown voltage.

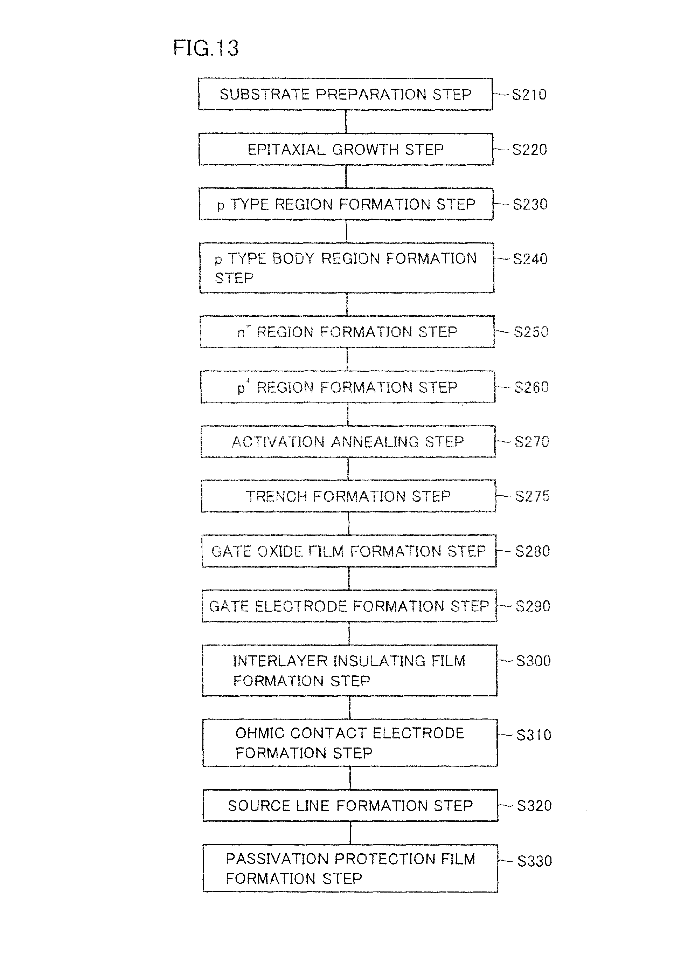

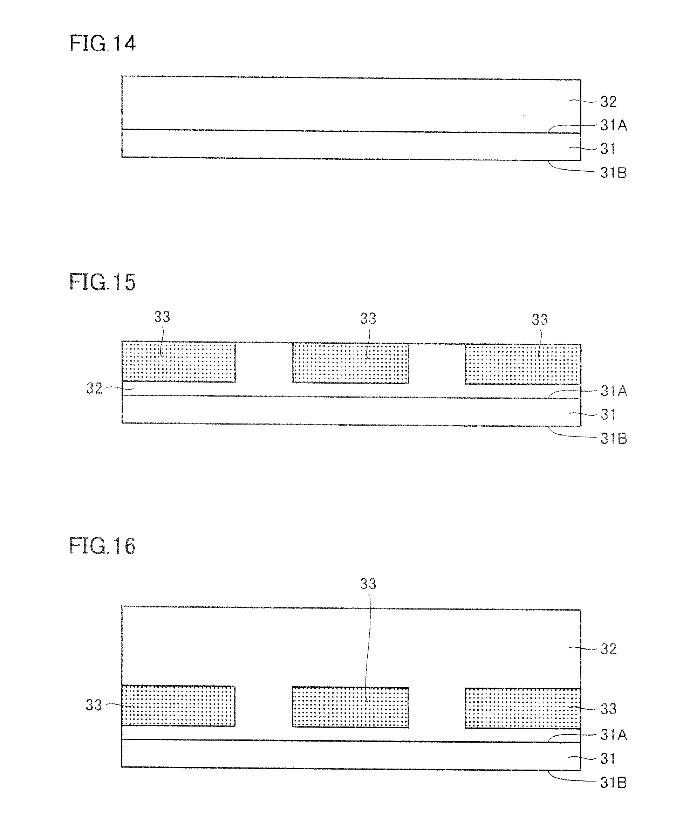

Next, an exemplary method of manufacturing MOSFET 3 in the second embodiment will be described with reference to Figs. 13 to 22. Referring to Fig. 13, in the method of manufacturing MOSFET 3 in this embodiment, a substrate preparation step is first performed as a step (S210). In this step (S210), referring to Fig. 14, silicon carbide substrate 31 including main surface 31 A having an off angle of 2° or more and 10° or less with respect to the {0001} plane is prepared.

Next, an epitaxial growth step is performed as a step (S220). In this step (S220), referring to Fig. 14, drift layer 32 made of silicon carbide is formed by epitaxial growth on one main surface 31A of silicon carbide substrate 31.

Next, a p type region formation step is performed as a step (S230). In this step (S230), referring to Figs. 14 and 15, ion implantation for forming p type regions 33 is performed. Specifically, Al (aluminum) ions are implanted into drift layer 32, for example, to form p type regions 33. The A1 ions are implanted to a concentration (density) of about 1 × 10¹⁶ cm⁻³, for example.

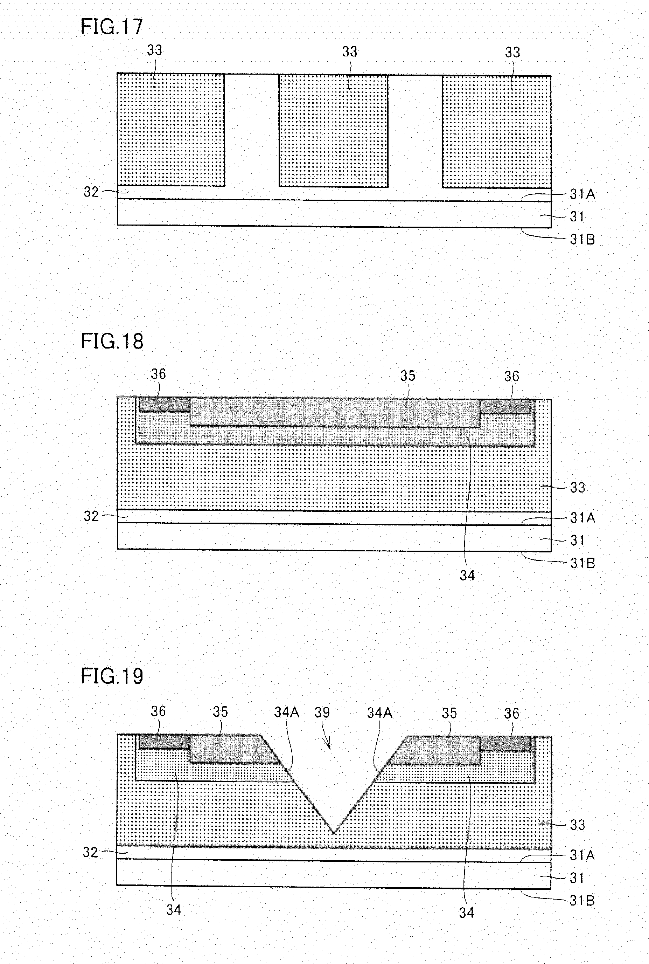

Here, the above steps (S220) and (S230) may be repeated in order to increase the thickness of drift layer 32. That is, referring to Figs. 16 and 17, drift layer 32 can be further formed by epitaxial growth on drift layer 32 in which p type regions 33 have been formed, and then p type regions 33 can be formed by ion implantation, to increase the thicknesses of drift layer 32 and p type regions 33.

Next, a p type body region formation step is performed as a step (S240). The following steps will be described with reference to Figs. 18 to 22, which show a cross section rotated by 90° around an axis perpendicular to main surface 31A of silicon carbide substrate 31 relative to Figs. 14 to 17. In this step (S240), referring to Fig. 18, Al ions are implanted into drift layer 32, for example, to form p type body regions 34. Next, an n⁺ region formation step is performed as a step (S250). In this step (S250), referring to Fig. 18, P (phosphorus) ions are implanted into p type body regions 34, for example, to form n⁺ regions 35 in p type body regions 34. Furthermore, a p⁺ region formation step is performed as a step (S260). In this step (S260), referring to Fig. 18, Al ions are implanted into p type body regions 34, for example, to form p⁺ regions 36 in p type body regions 34. Each of the ion implantations for forming p type regions 33, p type body regions 34, n⁺ regions 35 and p⁺ regions 36 can be performed by forming a mask layer, which is made of silicon dioxide (SiO₂ and has an opening in a desired region where the ion implantations should be performed, on the main surface of drift layer 32.

Next, an activation annealing step is performed as a step (S270). In this step (S270), heat treatment is conducted by heating to between about 1700°C and about 1800°C in an atmosphere of inert gas such as argon and maintaining it for 5 to 30 minutes, for example. As a result, the impurities (ions) implanted in the above steps (S230) to (S260) are activated.

Next, a trench formation step is performed as a step (S275). In this step (S275), trench 39 is formed with dry etching such as RIE, or thermal etching using halogenated gas such as chlorine or bromine, or a combination thereof, by using a mask made of silicon dioxide and having an opening in a desired region, for example. Specifically, referring to Figs. 18 and 19, after the mask having the opening is formed on n⁺ region 35, trench 39 is formed through n⁺ region 35 and p type body region 34 to extend in the direction along main surface 31A of silicon carbide substrate 31 (direction toward the back of the plane of paper in Fig. 19). Here, trench 39 is formed such that surface 34A of each of p type body regions 34 exposed at the surface (inclined surface) of the trench has an off angle of 50° or more and 65° or less with respect to the {0001} plane.

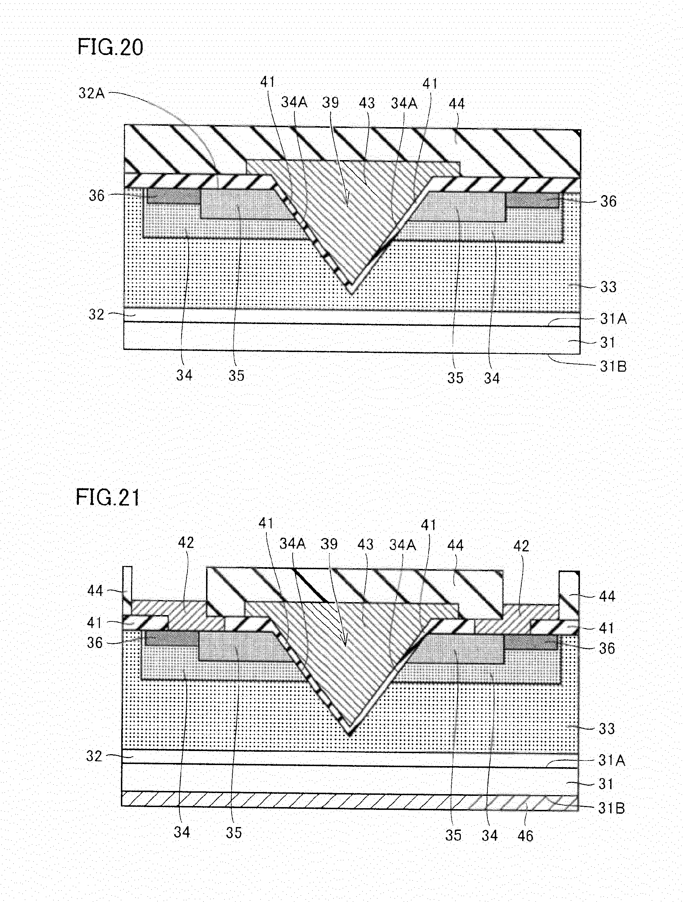

Next, a gate oxide film formation step is performed as a step (S280). In this step (S280), referring to Figs. 19 and 20, heat treatment is conducted by heating to between 1100°C and 1300°C in an oxygen atmosphere and maintaining it for about 60 minutes, for example, to form oxide film (gate oxide film) 41. Oxide film 41 is formed to cover main surface 32A of drift layer 32, and also to cover the surface of trench 39. After this step (S280), a NO annealing step and an Ar annealing step may be performed as in the first embodiment.

Next, a gate electrode formation step is performed as a step (S290). Referring to Fig. 20, in this step (S290), first, a polysilicon film (conductor film) is formed to fill trench 39 with LPCVD, for example. Then, a mask is formed with photolithography, and the polysilicon film is processed with etching such as RIE, to form gate electrode 43 made of polysilicon which is a conductor including a highly concentrated impurity.

Next, an interlayer insulating film formation step is performed as a step (S300). In this step (S300), referring to Fig. 20, interlayer insulating film 44 made of SiO₂ which is an insulator is formed with P-CVD, for example, to surround gate electrode 43 above main surface 32A. The thickness of interlayer insulating film 24 may be set at about 1 µm, for example. Next, referring to Fig. 21, interlayer insulating film 24 is formed into a desired shape with photolithography and etching.

Next, an ohmic contact electrode formation step is performed as a step (S310). In this step (S310), referring to Fig. 21, a nickel (Ni) film formed with evaporation, for example, is heated and silicidized, to form source contact electrodes 22 and drain electrode 26.

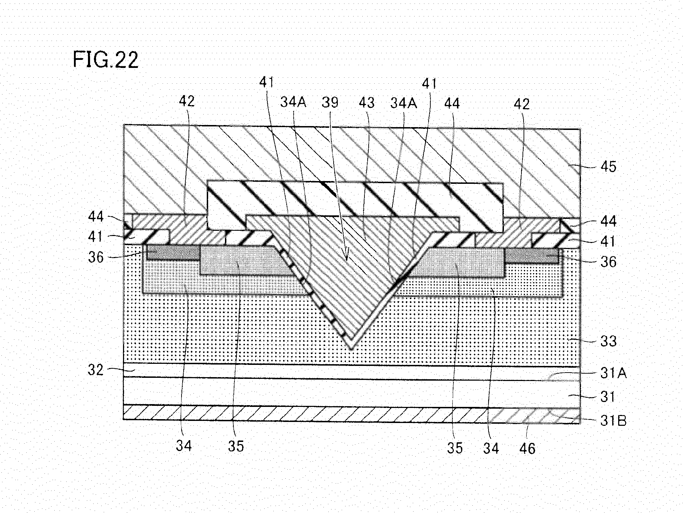

Next, a source line formation step is performed as a step (S320). In this step (S320), referring to Figs. 21 and 22, source line 45 which is a conductor is formed with evaporation, for example, to surround interlayer insulating film 44 and to extend to the upper surfaces of source contact electrodes 42 above main surface 32A. Source line 45 can be formed by successively evaporating Ti (titanium) having a thickness of 50 to 200 nm, Al having a thickness of 2 to 8 µm, and AlSi.

Next, a passivation protection film formation step is performed as a step (S330). In this step (S330), a passivation protection film is formed to cover source line 45. The passivation protection film can be formed by forming a film made of an insulator such as SiO₂, SiN, and/or polyimide and having a thickness of about 0.5 µm to about 3 µm, for example. Following the above procedure, MOSFET 3 in this embodiment shown in Fig. 12 is completed.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The semiconductor device of the present invention can be applied particularly advantageously to a semiconductor device of which increased flexibility in setting a threshold voltage is required.

### REFERENCE SIGNS LIST

1, 3 MOSFET; 11, 31 silicon carbide substrate; 11A, 11B, 31A, 31B main surface; 12, 32 drift layer; 12A, 32A main surface; 13, 33 p type region; 14, 34 p type body region; 14A region; 15, 35 n⁺ region; 16, 36 p⁺ region; 21, 41 gate oxide film (oxide film); 22, 42 source contact electrode; 23, 43 gate electrode; 24, 44 interlayer insulating film; 25, 45 source line; 26, 46 drain electrode; 27 passivation protection film; 34A surface; 39 trench.

## Claims

1. A semiconductor device (1, 3) comprising:
a substrate (11, 31) made of silicon carbide;
a semiconductor layer (12, 32) made of silicon carbide of a first conductivity type, which is formed on said substrate (11, 31) and includes a surface (14A, 34A) having an off angle of 50° or more and 65° or less with respect to a {0001} plane; and
an insulating film (21, 41) formed on and in contact with said surface (14A, 34A) of said semiconductor layer (12, 32),
said semiconductor layer (12, 32) including a body region (14, 34) of a second conductivity type different from said first conductivity type, which is formed to include a region in contact with said insulating film (21, 41),
said body region (14, 34) having an impurity density of 5 × 10¹⁶ cm⁻³ or more, and
a plurality of regions (13, 33) of said second conductivity type located apart from one another in a direction perpendicular to a thickness direction of said semiconductor layer (12, 32) being arranged in a region in said semiconductor layer (12, 32) lying between said body region (14, 34) and said substrate (11, 31).

2. The semiconductor device (1, 3) according to claim 1, wherein
an angle formed between an off orientation of said surface (14A, 34A) and a <01-10> direction is 5° or less.

3. The semiconductor device (1, 3) according to claim 2, wherein
said surface (14A, 34A) has an off angle of -3° or more and 5° or less with respect to a {03-38} plane in the <01-10> direction.

4. The semiconductor device (1, 3) according to claim 1, wherein
an angle formed between an off orientation of said surface (14A, 34A) and a <-2110> direction is 5° or less.

5. The semiconductor device (1, 3) according to claim 1, wherein
said surface (14A, 34A) is a surface of a carbon face side of silicon carbide.

6. The semiconductor device (1, 3) according to claim 1, wherein
said body region (14, 34) has an impurity density of 1 × 10²⁰ cm⁻³ or less.

7. The semiconductor device (1,3) according to claim 1, being of a normally off type.

8. The semiconductor device (1, 3) according to claim 1, wherein
said insulating film (21, 41) has a thickness of 25 nm or more and 70 nm or less.

9. The semiconductor device (1, 3) according to claim 1, wherein
said first conductivity type is n type, and said second conductivity type is p type.

10. The semiconductor device (1, 3) according to claim 9, wherein
said body region (14, 34) has an impurity density of 8 × 10¹⁶ cm⁻³ or more and 3 × 10¹⁸ cm⁻³ or less.

## Amended claims

### Amended claims under Art. 19.1 PCT

**1.** (Amended) A semiconductor device (1,3) comprising:
a substrate (11, 31) made of silicon carbide;
a semiconductor layer (12, 32) made of silicon carbide of a first conductivity type, which is formed on said substrate (11, 31) and includes a surface (14A, 34A) having an off angle of 50° or more and 65° or less with respect to a {0001} plane; and
an insulating film (21, 41) formed on and in contact with said surface (14A, 34A) of said semiconductor layer (12, 32),
said semiconductor layer (12,32) including a body region (14, 34) of a second conductivity type different from said first conductivity type, which is formed to include a region in contact with said insulating film (21, 41),
said body region (14, 34) having an impurity density of 5 x 10¹⁷ cm⁻³ or more, and
a plurality of regions (13, 33) of said second conductivity type located apart from one another in a direction perpendicular to a thickness direction of said semiconductor layer (12, 32) being arranged in a region in said semiconductor layer (12, 32) lying between said body region (14, 34) and said substrate (11,31).

**2.** The semiconductor device (1, 3) according to claim 1, wherein
an angle formed between an off orientation of said surface (14A, 34A) and a <01-10> direction is 5° or less.

**3.** The semiconductor device (1, 3) according to claim 2, wherein
said surface (14A, 34A) has an off angle of -3° or more and 5° or less with respect to a {03-38} plane in the <01-10> direction.

**4.** The semiconductor device (1, 3) according to claim 1, wherein
an angle formed between an off orientation of said surface (14A, 34A) and a <-2110> direction is 5° or less.

**5.** The semiconductor device (1, 3) according to claim 1, wherein
said surface (14A, 34A) is a surface of a carbon face side of silicon carbide.

**6.** The semiconductor device (1, 3) according to claim 1, wherein
said body region (14, 34) has an impurity density of 1 × 10²⁰ cm⁻³ or less.

**7.** The semiconductor device (1, 3) according to claim 1, being of a normally off type.

**8.** The semiconductor device (1, 3) according to claim 1, wherein
said insulating film (21, 41) has a thickness of 25 nm or more and 70 nm or less.

**9.** The semiconductor device (1, 3) according to claim 1, wherein
said first conductivity type is n type, and said second conductivity type is p type.

**10.** The semiconductor device (1,3) according to claim 9, wherein
said body region (14, 34) has an impurity density of 8 × 10¹⁶ cm⁻³ or more and 3 × 10¹⁸ cm⁻³ or less.
